# EUROPEAN PATENT SPECIFICATION

(11) **EP 0 372 705 B1**
(45) Date of publication and mention of the grant of the patent: **04.12.1996**
(21) Application number: 89311057.7
(22) Date of filing: 26.10.1989
(51) Int. Cl.: H03G 3/20

(54) **RF amplifier bias circuit**
Vorspannungsschaltung für RF-Verstärker
Circuit de polarisation pour amplificateur RF

(30) Priority: 08.12.1988 GB 8828635
(43) Date of publication of application: 13.06.1990
(73) Proprietor: Hewlett-Packard Company, Palo Alto, California 94304 (US)
(72) Inventor: Reading, Ian, West Lothian Scotland (GB)
(74) Representative: Coker, David Graeme

(56) References cited:
- FR-A- 2 210 335
- US-A- 3 581 222
- US-A- 4 458 213
- US-A- 4 606 075
- WIRELESS WORLD, vol. 81, no. 1477, September 1975, pages 417-422, Haywards Health, GB; W.P. O'REILLY: "Transmitter power amplifier design - 1"
- ELECTRONICS, vol. 44, no. 18, 30th August 1971, pages 52-56, New York, US; M.F. FARLEY: "Digital approach provides precise, progamable AGC"
- POST OFFICE ELECTRICAL ENGINEERS JOURNAL, vol. 62, no. 4, January 1970, pages 213-217, London, GB; N.P. McKAY: "Wideband signal-limiters"

## Description

The present invention relates to an RF amplifier bias circuit. Early bias of transistor amplifiers was accomplished using purely resistive elements. For many reasons this is not the best approach to biasing broad band RF amplifiers. Typically the high frequency RF transistor, around which the RF amplifier stage is constructed, has its bias conditions [collector current (Ic) and collector voltage (Vc)] maintained by another, lower performance transistor circuit. This technique is known as Active Biasing, and is employed in many types of RF amplifier.

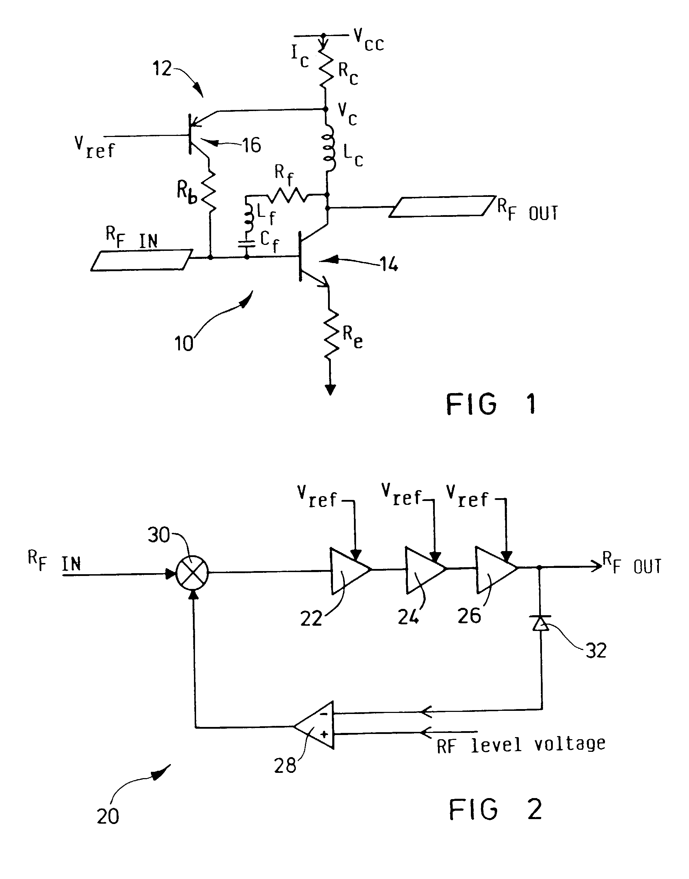

Figure 1 of the accompanying drawings shows a conventional active bias arrangement for an RF amplifier. An RF amplifier is indicated at 10 and an active bias circuit is indicated at 12.

The RF amplifier 10 comprises an npn transistor 14 having a feedback stabilizing arrangement comprising a resistor R_{F}, inductor L_{F} (RF choke), and capacitor C_{F}. The transistor 14 has an inductor L_{C} connected to its collector lead and has a grounded resistor Re connected to its emitter lead. The input and output RF signals are indicated at RF_{IN} and RF_{OUT} respectively.

The active bias circuit 12 comprises a pnp transistor 16 having a resistor Rb connected to its collector lead and a bias resistor R_{c} connected to its emitter lead. The bias resistor R_{c} is also connected to the inductor L_{c}.

During operation, a fixed reference voltage V_{ref} is supplied to the base of the transistor 16 and the supply voltage is V_{cc}. The collector current I_{c} of the transistor 14 is given by:${\text{I}}_{\text{c}} \text{=} \frac{{\text{V}}_{\text{cc}} {\text{- V}}_{\text{c}}}{\text{Rc}}$

The collector voltage V_{c} of the transistor 14 is given by:${\text{V}}_{\text{c}} {\text{= V}}_{\text{ref}} \text{+ 0.7V}$

Signal generators, and some other applications of broad band RF power amplifiers require operation in two modes:
i) Moderate output power (around 12dBm) with good harmonic performance (-40dBc).
ii) High output power (around 20dBm) with unspecified harmonic performance.

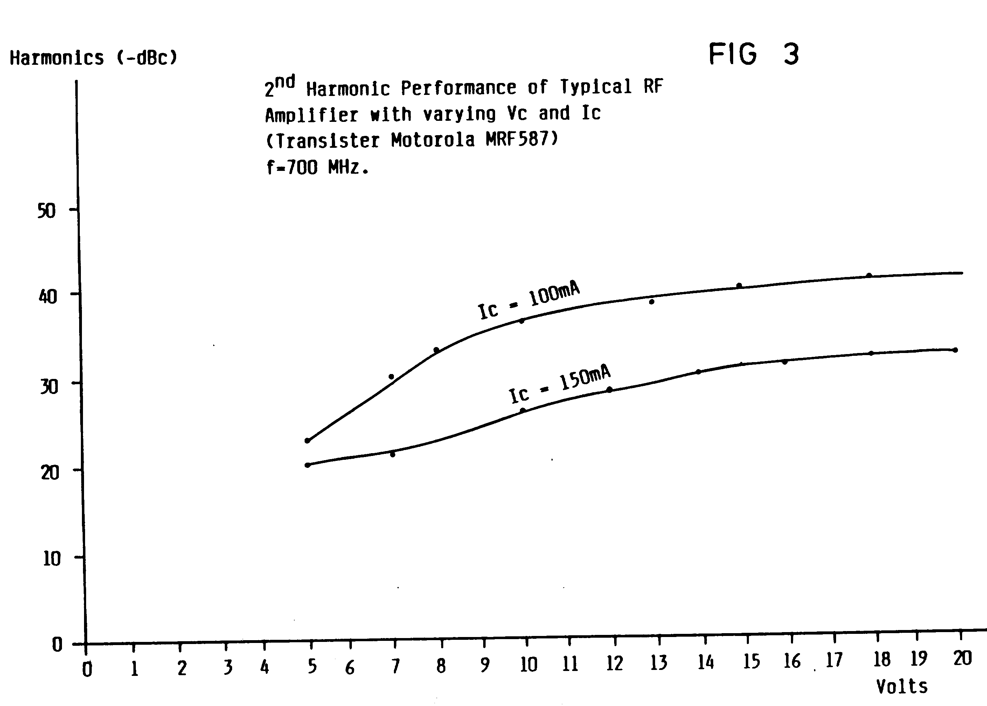

In a signal generator application, the RF amplifier forms part of a level feedback control system (ALC loop, Automatic Level Control) of the type shown in Figure 2.

In Figure 2 a feedback control system is indicated generally at 20 and comprises three RF amplifiers 22,24 and 26, a differential amplifier 28 and a modulator 30. The modulator 30 is typically a three PIN diode modulator. The RF amplifier 26 is connected to the negative input of the differential amplifier 28 via a detector diode 32. An RF level control voltage is supplied to the positive input of the comparator. The RF level control voltage can simply be derived from a variable voltage source or a potential divider. Preferably however, it is generated under microprocessor control using known techniques. The RF power output from the amplifier is detected and compared with the RF level control voltage which is derived elsewhere in the instrument. The difference between the desired and detected RF level is used to generate an error signal which controls the modulator 30, changing the RF level input to the RF amplifier 22. In this way, the RF power out of the amplifier can be continuously varied through the two modes of operation mentioned above.

Typical RF transistors used in RF amplifiers such as the Motorola MRF 581, have power output and harmonic performance which vary with Vc and Ic. In addition the product Vc.Ic constitutes the power dissipation in the transistor which is limited by the device packaging, heatsinking and specification. In conventional active biasing, a single value of Vc and Ic are chosen to give good performance in both operating modes above, while keeping a low power dissipation. The relationships between Vc, Ic and transistor performance are such that increasing Vc yields better harmonic performance with little effect on maximum output power, while increasing Ic improves maximum output power before clipping and compression, with some degradation of harmonics.

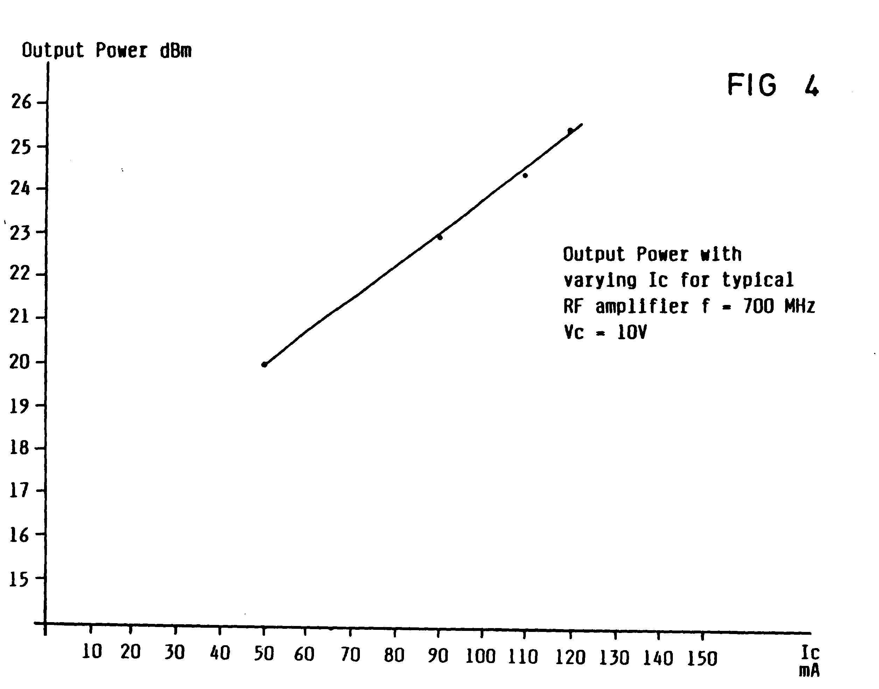

Figures 3 and 4 illustrate schematically the relationship between Vc and harmonic performance and between Ic and power output respectively.

US 4 458 213 describes a closed-loop feedback arrangement for stabilizing the output quiescent current of a class AB amplifier against the effects of temperature variations. To this end, a voltage representative of the collector current level is supplied to an integrator together with a reference voltage, to produce a signal representative of their difference. This difference signal is used to produce a bias voltage for the amplifier's output transistors, to maintain a constant quiescent collector current determined by the reference voltage.

According to one aspect of the present invention there is provided an amplifier circuit for generating an output voltage, comprising:
an amplifier having an input and an output;
a biasing circuit for and coupled to said amplifier;
control means for generating an amplifier output power level control voltage; and
means for coupling said control means to said biasing circuit in an open loop manner for dynamically controlling the operating point of said amplifier in response to the power level control voltage such that current and voltage parameters defining said operating point vary in opposite sense to one another in coordination with change in amplifier output power level.

According to another aspect of this invention there is provided a method of operating an amplifier circuit comprising an amplifier and a biasing circuit for said amplifier, said method comprising the following steps:
operating said amplifier so as to produce an output signal;
generating an amplifier output power level control voltage;
applying said power level control voltage to said biasing circuit in an open loop manner; and
dynamically controlling the operating point of said amplifier with said biasing circuit in response to the power level control voltage such that current and voltage parameters defining said operating point vary in opposite sense to one another in coordination with change in amplifier output power level.

According to a further aspect of this invention there is provided a system comprising:
amplifier means having an input and an output;
control means for generating an amplifier output level control voltage;
comparison means coupled to said amplifier means and said control means for generating an error signal representing the difference between said output and said level control voltage;
modulating means coupled to said amplifier means and said comparison means for modulating the input to said amplifier means with said error signal; and
bias means coupled to said amplifier means and said control means as part of an open loop for varying the operating bias point of the amplifier means in response to said level control voltage such that current and voltage parameters defining said operating point vary in opposite sense to one another.

Dynamic biasing in this way allows the operating bias point (Vc and Ic) to be continuously varied as a function of desired output power. When a moderate output is desired, with good harmonics, a high value of Vc can be used with a low value of Ic. When a high RF power with unspecified harmonics is required a high value of Ic can be used. Vc is reduced in sympathy with the increasing Ic to maintain low dissipation.

Dynamic biasing has the advantage of using the RF transistor optimally for both high power and good harmonic performance, while maintaining low dissipation. This has the added advantage in signal generator applications of improving amplifier linearity with varying power and so improving amplitude modulation (applied using the ALC loop) accuracy and distortion. By using RF transistors at more optimum values of Ic and Vc, the amplifier is made more tolerant of device to device variations. However, the new approach entails a small overhead in components needed to implement the bias variation.

An embodiment of the present invention will now be described, by way of example, with reference to the accompanying drawings in which:
Figure 5 shows a feedback control system according to the present invention;
Figure 6 shows in more detail the dynamic bias control amplifier of Figure 5.

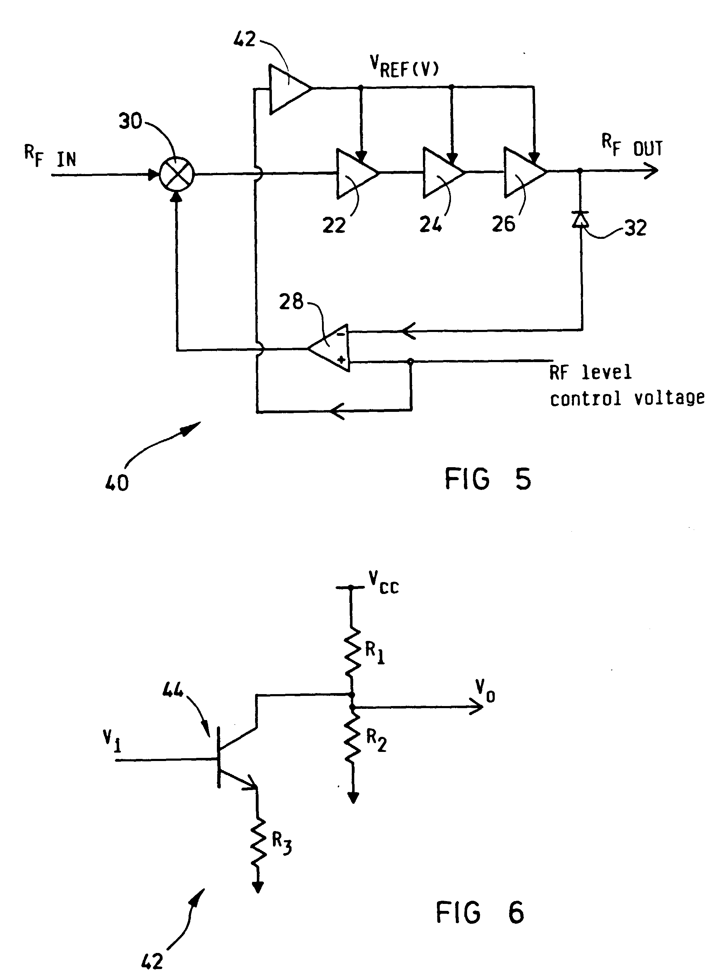

In Figure 5 the same reference numerals are used for components which are common with Figure 2. In addition, the feedback control system of Figure 5, which is indicated generally at 40, comprises a dynamic bias control amplifier 42 to which is supplied the RF level control voltage. The output from the dynamic bias control amplifier 42 supplies a variable reference voltage V_{REF(V)} to the three RF amplifiers 22, 24 and 26 so that the operating bias point of these three amplifiers varies continuously in dependence upon desired resultant output level.

In practice V_{REF(V)} is likely to be proportional to the collector voltage V_{c}. for the amplifiers 22,24 and 26. The amplifiers 22,24 and 26 may all operate with the same collector voltage Vc although their collector currents Ic will differ according to the value of their collector resistors Rc. In other embodiments, it may be desirable for the three amplifiers 22,24 and 26 to operate at different collector voltages in which case a separate dynamic bias control amplifier may be provided for each RF amplifier.

Figure 6 shows the components of the dynamic bias amplifier 42 and these are a transistor 44 and three resistors R₁, R₂ and R₃. The emitter lead of the transistor 44 is connected via resistor R₃ to ground and the collector lead is connected to a voltage divider formed by resistors R₁, and R₂ which are connected to a supply voltage V_{cc}. The input voltage Vᵢ to base of the transistor 44 is equal to, or derived from, the RF level control voltage. The output voltage Vₒ is equal to, or forms the basis of, the. variable reference voltage V_{REF(V)}.

The output voltage is Vₒ is derived as follows: 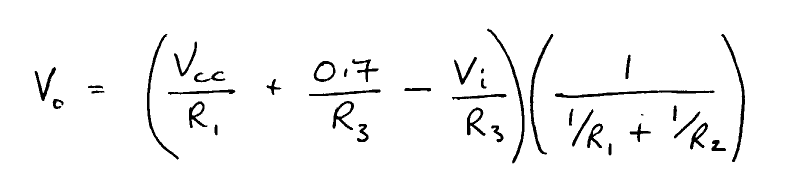 assuming that the voltage drop across the base-emitter junction of the transistor 44 is 0.7V.

Typical values for these variables are as follows:
R₁ = 7.5 kΩ
R₂ = 10 kΩ
R₃ = 10 kΩ
Vᵢ = 0 to 8V
Vₒ = 9 to 12 V
V_{cc} = 15 V

Thus the control voltage for the automatic level control (ALC) loop is a signal which varies in proportion to the desired RF power and this signal is also used to control the ratio of V_{c} and I_{c} applied to the or each RF amplifier.

Dynamic biasing in this way allows the operating bias point (Vc and Ic) to be continuously varied as a function of desired output power. When a moderate output is desired, with good harmonics, a high value of Vc can be used with a low value of Ic. When a high RF power with unspecified harmonics is required a high value of Ic can be used. Vc is reduced in sympathy with the increasing Ic to maintain low dissipation.

Dynamic biasing has the advantage of using the RF transistor optimally for both high power and good harmonic performance, while maintaining low dissipation.

This has the added advantage in signal generator applications of improving amplifier linearity with varying power and so improving amplitude modulation (applied using the ALC loop) accuracy and distortion. By using RF transistors at more optimum values of Ic and Vc, the amplifier is made more tolerant of device to device variations. However, this new approach entails a small overhead in components needed to implement the bias variation.

It will be understood that the present invention is applicable to any RF amplifier where linearity and harmonic performance are important.

Minor modifications to reduce the effect of power dissipation in the detector diode 32 on the output signal RF_{OUT} (Figure 5) may be made. For example the detector diode 32 may be connected to the output of the second RF amplifier 24 or may be connected to an extra amplifier (not shown) connected to the output of the amplifier 24 and arranged in parallel with the amplifier 26.

The number of RF amplifiers used in a feedback control circuit will of course vary according to requirements.

The invention may be implemented in the form of components surface mounted on a printed circuit board, as separate components hard-wired together, on a microprocessor or in any other suitable form.

Although the present invention has been described and claimed with respect to an RF amplifier it will be understood that the invention may be useful in relation to a DC amplifier.

## Claims

1. An amplifier circuit for generating an output voltage, comprising:
an amplifier (26) having an input and an output;
a biasing circuit (42) for and coupled to said amplifier;
control means for generating an amplifier output power level control voltage; and
means for coupling said control means to said biasing circuit (42) in an open loop manner for dynamically controlling the operating point of said amplifier (26) in response to the power level control voltage such that current and voltage parameters defining said operating point vary in opposite sense to one another in coordination with change in amplifier output power level.

2. The amplifier circuit of claim 1, wherein said biasing circuit (42) comprises another amplifier.

3. The amplifier circuit of claim 1 or claim 2, wherein said amplifier (26) comprises an RF amplifier.

4. The amplifier circuit of any one of the preceding claims, wherein said control means includes means (28,30,32) for comparing a signal indicative of said amplifier output power level with said output power level control voltage, generating a difference signal indicative of the difference between said signal and said voltage, and controlling the input power level of said amplifier on the basis of at least said difference signal.

5. A method of operating an amplifier circuit comprising an amplifier (26) and a biasing circuit (42) for said amplifier, said method comprising the following steps:
operating said amplifier (26) so as to produce an output signal;
generating an amplifier output power level control voltage;
applying said power level control voltage to said biasing circuit (42) in an open loop manner; and
dynamically controlling the operating point of said amplifier (26) with said biasing circuit (42) in response to the power level control voltage such that current and voltage parameters defining said operating point vary in opposite sense to one another in coordination with change in amplifier output power level.

6. The method of claim 5, wherein said amplifier comprises a plurality of cascaded amplifiers (22,24,26) and further comprising the step of dynamically controlling the respective operating points of said plurality of cascaded amplifiers.

7. The method of claim 5 or claim 6, including the steps of comparing (28,32) a signal indicative of said amplifier output power level with said output power level control voltage, generating a difference signal indicative of the difference between said signal and said voltage, and controlling (30) the input power level of said amplifier on the basis of at least said difference signal.

8. A system comprising:
amplifier means (26) having an input and an output;
control means for generating an amplifier output level control voltage;
comparison means (28,32) coupled to said amplifier means and said control means for generating an error signal representing the difference between said output and said level control voltage;
modulating means (30) coupled to said amplifier means (26) and said comparison means (28,32) for modulating the input to said amplifier means with said error signal; and
bias means (42) coupled to said amplifier means (26) and said control means as part of an open loop for varying the operating bias point of the amplifier means in response to said level control voltage such that current and voltage parameters defining said operating point vary in opposite sense to one another.

9. The system of claim 8, wherein said amplifier means (26) comprises a plurality of cascaded amplifiers coupled to said bias means.

10. The system of claim 8 or claim 9, wherein said amplifier means comprises an RF amplifier.

## Patentansprüche

1. Eine Verstärkerschaltung zum Erzeugen einer Ausgangsspannung, mit folgenden Merkmalen:
einem Verstärker (26) mit einem Eingang und einem Ausgang;
einer Vorspannungsschaltung (42) für den Verstärker, die mit demselben gekoppelt ist;
einer Steuerungseinrichtung zum Erzeugen einer Verstärkerausgangsleistungspegel-Steuerspannung und
einer Einrichtung zum Koppeln der Steuereinrichtung mit der Vorspannungsschaltung (42) auf die Art und Weise einer offenen Schleife zum dynamischen Steuern des Arbeitspunkts des Verstärkers (26) als Reaktion auf die Leistungspegel-Steuerspannung, derart, daß ein Strom- und ein Spannungsparameter, die den Arbeitspunkt definieren, in zueinander entgegengesetztem Sinn in Koordination mit einer Veränderung des Verstärkerausgangsleistungspegels variieren.

2. Verstärkerschaltung gemäß Anspruch 1, bei der die Vorspannungsschaltung (42) einen weiteren Verstärker aufweist.

3. Die Verstärkerschaltung gemäß Anspruch 1 oder 2, bei der der Verstärker (26) einen Hochfrequenzverstärker aufweist.

4. Die Verstärkerschaltung gemäß einem beliebigen der vorhergehenden Ansprüche, bei der die Steuereinrichtung eine Einrichtung (28, 30, 32) zum Vergleichen eines Signals, das den Verstärkerausgangsleistungspegel anzeigt, mit der Ausgangsleistungspegel-Steuerspannung, zum Erzeugen eines Differenzsignals, das die Differenz zwischen dem Signal und der Spannung anzeigt, und zum Steuern des Eingangsleistungspegels des Verstärkers auf der Basis von zumindest dem Differenzsignal aufweist.

5. Ein Verfahren zum Betreiben einer Verstärkerschaltung mit einem Verstärker (26) und einer Vorspannungsschaltung (42) für den Verstärker, wobei das Verfahren die folgenden Schritte aufweist:
Betreiben des Verstärkers (26), um ein Ausgangssignal zu erzeugen;
Erzeugen einer Verstärkerausganqsleistungspegel-Steuerspannung;
Anlegen der Leistungspegel-Steuerspannung an die Vorspannungsschaltung (42) auf die Art und Weise einer offenen Schleife; und
dynamisches Steuern des Arbeitspunkts des Verstärkers (26) mit der Vorspannungsschaltung (42) als Reaktion auf die Leistungspegel-Steuerspannung, derart, daß ein Strom- und ein Spannungsparameter, die den Arbeitspunkt definieren, in zueinander entgegengesetztem Sinn in Koordination mit einer Veränderung des Verstärkerausgangsleistungspegels variieren.

6. Das Verfahren gemäß Anspruch 5, bei dem der Verstärker eine Mehrzahl von kaskadierten Verstärkern (22, 24, 26) aufweist, wobei das Verfahren den Schritt des dynamischen Steuerns der jeweiligen Arbeitspunkte der Mehrzahl von kaskadierten Verstärkern aufweist.

7. Das Verfahren gemäß Anspruch 5 oder 6, das die Schritte des Vergleichens (28, 32) eines Signals, das den Verstärkerausgangsleistungspegel anzeigt, mit der Ausgangsleistungspegel-Steuerspannung, des Erzeugens eines Differenzsignals, das die Differenz zwischen dem Signal und der Spannung anzeigt, und des Steuerns (30) des Eingangsleistungspegels des Verstärkers auf der Basis von zumindest dem Differenzsignal aufweist.

8. Ein System mit folgenden Merkmalen:
einer Verstärkereinrichtung (26) mit einer Eingabe und einer Ausgabe;
einer Steuerungseinrichtung zum Erzeugen einer Verstärkerausgangspegel-Steuerspannung;
einer Vergleichseinrichtung (28, 32), die mit der Verstärkereinrichtung und der Steuereinrichtung gekoppelt ist, zum Erzeugen eines Fehlersignals, das die Differenz zwischen der Ausgabe und der Pegelsteuerspannung darstellt;
einer Moduliereinrichtung (30), die mit der Verstärkereinrichtung (26) und mit der Vergleichseinrichtung (28, 32) gekoppelt ist, zum Modulieren der Eingabe in die Verstärkereinrichtung mit dem Fehlersignal; und
einer Vorspannungseinrichtung (42), die mit der Verstärkereinrichtung (26) und mit der Steuereinrichtung als Teil einer offenen Schleife gekoppelt ist, zum Variieren des Vorspannungsarbeitspunktes der Verstärkereinrichtung als Reaktion auf die Pegelsteuerspannung, derart, daß ein Strom- und ein Spannungsparameter, die den Arbeitspunkt definieren, in zueinander entgegengesetztem Sinn variieren.

9. Das System gemäß Anspruch 8, bei dem die Verstärkereinrichtung (26) eine Mehrzahl von kaskadierten Verstärkern aufweist, die mit der Vorspannungseinrichtung gekoppelt sind.

10. Das System gemäß Anspruch 8 oder 9, bei dem die Verstärkereinrichtung einen Hochfrequenzverstärker aufweist.

## Revendications

1. Circuit d'amplification pour générer une tension de sortie, comprenant:
un amplificateur (26) ayant une entrée et une sortie;
un circuit de polarisation (42) destiné audit amplificateur et couplé avec celui-ci;
des moyens de commande pour générer une tension de commande de niveau de puissance de sortie d'amplificateur; et
des moyens pour coupler lesdits moyens de commande audit circuit de polarisation (42) en boucle ouverte afin de commander dynamiquement le point de fonctionnement dudit amplificateur (26) en réponse à la tension de commande de niveau de puissance de telle façon que des paramètres de courant et de tension définissant ledit point de fonctionnement varient en sens contraire l'un par rapport à l'autre de manière coordonnée avec une variation dans le niveau de puissance de sortie d'amplificateur.

2. Circuit d'amplification selon la revendication 1, dans lequel ledit circuit de polarisation (42) comprend un autre amplificateur.

3. Circuit d'amplification selon la revendication 1 ou 2, dans lequel ledit amplificateur (26) comprend un amplificateur haute fréquence.

4. Circuit d'amplification selon l'une quelconque des revendications précédentes, dans lequel lesdits moyens de commande incluent des moyens (28, 30, 32) pour comparer un signal indicatif dudit niveau de puissance de sortie d'amplificateur à ladite tension de commande de niveau de puissance de sortie, générer un signal de différence indicatif de la différence entre ledit signal et ladite tension, et commander le niveau de puissance d'entrée dudit amplificateur sur la base d'au moins ledit signal de différence.

5. Procédé de fonctionnement d'un circuit d'amplification comprenant un amplificateur (26) et un circuit de polarisation (42) destiné audit amplificateur, ledit procédé comprenant les étapes suivantes consistant à:
faire fonctionner ledit amplificateur (26) afin de produire un signal de sortie;
générer une tension de commande de niveau de puissance de sortie d'amplificateur;
appliquer ladite tension de commande de niveau de puissance audit circuit de polarisation (42) en boucle ouverte; et
commander dynamiquement le point de fonctionnement dudit amplificateur (26) avec ledit circuit de polarisation (42) en réponse à la tension de commande de niveau de puissance de telle façon que des paramètres de courant et de tension définissant ledit point de fonctionnement varient en sens contraire l'un par rapport à l'autre de manière coordonnée avec une variation dans le niveau de puissance de sortie d'amplificateur.

6. Procédé selon la revendication 5, dans lequel ledit amplificateur comprend une pluralité d'amplificateurs en cascade (22, 24, 26) et comprend également l'étape consistant à commander dynamiquement les points de fonctionnement respectifs de ladite pluralité d'amplificateurs en cascade.

7. Procédé selon la revendication 5 ou 6, incluant les étapes consistant à comparer (28, 32) un signal indicatif dudit niveau de puissance de sortie d'amplificateur à ladite tension de commande de niveau de puissance de sortie, générer un signal de différence indicatif de la différence entre ledit signal et ladite tension, et commander (30) le niveau de puissance d'entrée dudit amplificateur sur la base d'au moins ledit signal de différence.

8. Système comprenant:
des moyens d'amplification (26) ayant une entrée et une sortie;
des moyens de commande pour générer une tension de commande de niveau de sortie d'amplificateur;
des moyens de comparaison (28, 32) couplés auxdits moyens d'amplification et auxdits moyens de commande pour générer un signal d'erreur représentant la différence entre ladite sortie et ladite tension de commande de niveau;
des moyens de modulation (30) couplés auxdits moyens d'amplification (26) et auxdits moyens de comparaison (28, 32) pour moduler l'entrée destinée auxdits moyens d'amplification avec ledit signal d'erreur; et
des moyens de polarisation (42) couplés auxdits moyens d'amplification (26) et auxdits moyens de commande en tant que partie d'une boucle ouverte pour faire varier le point de fonctionnement de polarisation des moyens d'amplification en réponse à ladite tension de commande de niveau de telle façon que des paramètres de courant et de tension définissant ledit point de fonctionnement varient en sens contraire l'un par rapport à l'autre.

9. Système selon la revendication 8, dans lequel lesdits moyens d'amplification (26) comprennent une pluralité d'amplificateurs en cascade couplés auxdits moyens de polarisation.

10. Système selon la revendication 8 ou 9, dans lequel lesdits moyens d'amplification comprennent un amplificateur haute fréquence.
